# EUROPEAN PATENT APPLICATION

(11) **EP 4 782 856 A1**
(43) Date of publication of application: **29.07.2026**
(21) Application number: 25867146.0
(22) Date of filing: 20.10.2025
(51) Int. Cl.: G01R 31/396, G01R 31/392, G01R 31/385, G01R 31/367, G01R 31/36, H01M 4/04, H01J 7/00

(54) **BATTERY MANAGEMENT DEVICE, BATTERY MANAGEMENT METHOD AND BATTERY SYSTEM**

(30) Priority: 22.11.2024 KR 20240168032
(71) Applicant: LG Energy Solution, Ltd., Seoul 07335 (KR)
(72) Inventor: YU, Hye In, Daejeon 34122 (KR); CHOI, Soon Ju, Daejeon 34122 (KR); CHOI, Dong In, Daejeon 34122 (KR)
(74) Representative: Goddar, Heinz J.
(86) International application number: PCT/KR2025/016607
(87) International publication number: WO 2026/111198

(57) **Abstract**

According to some embodiments, a battery management device includes an interface configured to acquire battery data of a battery having a composite negative electrode based on a first active material of a silicon series and a second active material of a graphite series, and a controller configured to calculate a first negative electrode loading of the first active material for the composite negative electrode and a second negative electrode loading of the second active material for the composite negative electrode based on the battery data, and diagnose a state of the composite negative electrode based on the first negative electrode loading and the second negative electrode loading.

## Description

### TECHNICAL FIELD

### Cross-reference to Related Applications

This application claims priority from Korean Patent Application No. 10-2024-0168032, filed on November 22, 2024, the disclosure of which is incorporated by reference herein.

### Technical Field

Embodiments disclosed in this document relate to a battery management device, a battery management method, and a battery system.

### BACKGROUND ART

Recently, research and development on secondary batteries has been actively conducted. Here, secondary batteries are batteries that can be charged and discharged, and may be interpreted as including both conventional Ni/Cd batteries, Ni/MH batteries, and recent lithium-ion batteries. Among secondary batteries, lithium ion batteries may have higher energy density than conventional Ni/Cd batteries, Ni/MH batteries, etc., and may be manufactured to be small and lightweight, and thus can therefore have high usability of power sources for mobile devices. Recently, the scope of use of the lithium ion batteries has expanded to include power sources for electric vehicles, and are attracting attention as a next-generation energy storage medium.

The energy density and charging performance of a battery may be affected by physical properties of a battery electrode. A battery negative electrode having a silicon (Si)-based active material may have excellent electrical conductivity and surface area, thereby implementing high energy density and charging performance. However, in the case of a silicon-based negative electrode, the volume change due to charging and discharging may be large, and when charging and discharging are repeated, the battery performance may be degraded due to a change in a negative electrode structure. In order to solve this problem, a method of mixing an active material of a silicon series and an active material of a graphite (Gr) series in the battery negative electrode has been used.

### DISCLOSURE OF THE INVENTION

### TECHNICAL PROBLEM

One of the objects of the embodiments disclosed in this document includes providing a battery management device, a battery management method, and a battery system capable of diagnosing a negative electrode degradation state according to a volume change caused by an active material of a silicon series in a silicon-based and graphite-based composite negative electrode.

The technical objectives of the embodiments disclosed in this document are not limited to the technical problems mentioned above, and other technical problems not mentioned will be clearly understood by those skilled in the art from the descriptions below.

### TECHNICAL SOLUTION

According to some embodiments, a battery management device includes an interface configured to acquire battery data of a battery having a composite negative electrode based on a first active material of a silicon series and a second active material of a graphite series, and a controller configured to calculate a first negative electrode loading of the first active material for the composite negative electrode and a second negative electrode loading of the second active material for the composite negative electrode based on the battery data, and diagnose a state of the composite negative electrode based on the first negative electrode loading and the second negative electrode loading.

According to some embodiments, the controller may be configured to diagnose the state of the composite negative electrode based on a variation in the first negative electrode loading and the second negative electrode loading according to an increase in the number of charging/discharging times of the battery.

According to some embodiments, the controller may be configured to diagnose the composite negative electrode such that a degradation of the first active material is smaller than a degradation of the second active material when a first trend in which the first negative electrode loading increases while the second negative electrode loading decreases is maintained as the number of charging/discharging times of the battery increases.

According to some embodiments, the controller may be configured to diagnose the composite negative electrode such that the degradation of the first active material is greater than the degradation of the second active material when the first trend transitions to a second trend in which the second negative electrode loading increases while the first negative electrode loading decreases.

According to some embodiments, the controller may be configured to diagnose the composite negative electrode as having progressed through a crystalline degradation stage and an amorphous degradation stage of the first active material when the first trend transitions to the second trend.

According to some embodiments, the controller may be configured to estimate a progress rate of the crystalline degradation stage and a progress rate of the amorphous degradation stage based on the first negative electrode loading and the second negative electrode loading when the first trend transitions to the second trend.

According to some embodiments, the controller may be configured to diagnose that lithium precipitation occurs in the composite negative electrode when the first trend is maintained, and diagnose that side reaction gas occurs in the composite negative electrode when the first trend transitions to the second trend.

According to some embodiments, a battery management method includes the steps of acquiring battery data of a battery having a composite negative electrode based on a first active material of a silicon series and a second active material of a graphite series, calculating a first negative electrode loading of the first active material for the composite negative electrode and a second negative electrode loading of the second active material for the composite negative electrode based on the battery data, and diagnosing a state of the composite negative electrode based on the first negative electrode loading and the second negative electrode loading.

According to some embodiments, the step of diagnosing the state of the composite negative electrode may include a step of diagnosing the state of the composite negative electrode based on a variation in the first negative electrode loading and the second negative electrode loading according to an increase in the number of charging/discharging times of the battery.

According to some embodiments, the step of diagnosing the state of the composite negative electrode may include a step of diagnosing the composite negative electrode such that a degradation of the first active material is smaller than a degradation of the second active material when a first trend in which the first negative electrode loading increases while the second negative electrode loading decreases is maintained as the number of charging/discharging times of the battery increases.

According to some embodiments, the step of diagnosing the state of the composite negative electrode may include a step of diagnosing the composite negative electrode such that the degradation of the first active material is greater than the degradation of the second active material when the first trend transitions to a second trend in which the second negative electrode loading increases while the first negative electrode loading decreases.

According to some embodiments, the step of diagnosing the state of the composite negative electrode may include a step of diagnosing the composite negative electrode as having progressed through a crystalline degradation stage and an amorphous degradation stage of the first active material when the first trend transitions to the second trend.

According to some embodiments, the step of diagnosing the state of the composite negative electrode may include a step of estimating a progress rate of the crystalline degradation stage and a progress rate of the amorphous degradation stage based on the first negative electrode loading and the second negative electrode loading when the first trend transitions to the second trend.

According to some embodiments, the step of diagnosing the state of the composite negative electrode may include a step of diagnosing that lithium precipitation occurs in the composite negative electrode when the first trend is maintained and a step of diagnosing that side reaction gas occurs in the composite negative electrode when the first trend transitions to the second trend.

According to some embodiments, a battery system includes a battery having a composite negative electrode based on a first active material of a silicon series and a second active material of a graphite series, a power device configured to perform at least one of charging and discharging of the battery, and a battery management device configured to acquire battery data of a battery, calculate a first negative electrode loading of the first active material for the composite negative electrode and a second negative electrode loading of the second active material for the composite negative electrode based on the battery data, and diagnose a state of the composite negative electrode based on the first negative electrode loading and the second negative electrode loading.

### ADVANTAGEOUS EFFECTS

According to the embodiments disclosed in this document, a battery management device, a battery management method, and a battery system capable of diagnosing a negative electrode degradation state according to a volume change caused by an active material of a silicon series in a silicon- and graphite-based composite negative electrode can be provided.

The technical effects according to the embodiments disclosed in this document are not limited to the above-mentioned effects, and other effects not mentioned will be clearly understood by those skilled in the art according to the disclosure of this document.

### BRIEF DESCRIPTION OF THE DRAWINGS

FIG. 1 illustrates components constituting a battery system according to some embodiments;
FIG. 2 illustrates components constituting a first battery management device according to some embodiments;
FIG. 3 illustrates a form in which a structure of a silicon series degrades due to charging and discharging according to some embodiments;
FIG. 4 illustrates silicon main degradation and graphite main degradation occurring in a composite negative electrode according to some embodiments;
FIG. 5 illustrates a degradation behavior of silicon main degradation and a degradation behavior of graphite main degradation according to some embodiments;
FIG. 6 illustrates degradation indicators used to diagnose a progress state of silicon main degradation according to some embodiments;
FIG. 7 illustrates steps constituting a first battery management method according to some embodiments;
FIG. 8 illustrates components constituting a second battery management device according to some embodiments;
FIG. 9 illustrates a degradation indicator used to diagnose a progress state of silicon main degradation according to some embodiments;
FIG. 10 illustrates steps constituting a second battery management method according to some embodiments;
FIG. 11 illustrates components constituting a third battery management device according to some embodiments;
FIG. 12 illustrates a volume change of a composite negative electrode due to charging and discharging according to some embodiments;
FIG. 13 illustrates a charging voltage profile representing a variation in voltage according to a variation in charging capacity of the entire battery according to some embodiments;
FIG. 14 illustrates a charging voltage profile representing a variation in voltage according to a variation in charging capacity of a composite negative electrode according to some embodiments;
FIG. 15 illustrates a charging behavior of an active material of a silicon series and a charging behavior of an active material of a graphite series in a composite negative electrode according to some embodiments;
FIG. 16 illustrates a swelling profile illustrating a variation in battery swelling according to a variation in charging capacity according to some embodiments;
FIG. 17 illustrates stages relating to a structure of graphite that changes during a charging process according to some embodiments;
FIG. 18 illustrates phase transition and volume variation of an NCM positive electrode during a charging process according to some embodiments; and
FIG. 19 illustrates steps constituting a third battery management method according to some embodiments.

### MODE FOR CARRYING OUT THE INVENTION

Hereinafter, embodiments described in this document will be described with reference to the accompanying drawings. However, this is not intended to limit the disclosure of present document to a specific embodiment, but should be understood to include various modifications, equivalents, and/or alternatives of the embodiments described in this document.

It should be understood that the embodiments of this document and the terms used therein are not intended to limit the technical features described in this document to specific embodiments, but rather include various modifications, equivalents, or substitutes of the embodiments. In connection with the description of the drawings, similar reference symbols may be used for similar or related components. A singular form of a noun corresponding to an item may include one or more of the items unless the relevant context clearly indicates otherwise.

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof. Terms such as "first", "second", "firstly", "secondly", "A", "B", "(a)" or "(b)" may be used merely to distinguish one component from another component and, unless otherwise stated, do not limit the components in any other respect (e.g., importance or order).

In this document, when a component (e.g., a first component) is referred to as being "connected", "coupled" or "joined" to another component (e.g., a second component), with or without the terms "functionally" or "communicatively", it means that a component can be connected to another component directly (e.g., in a wired manner or wirelessly), or indirectly (e.g., through a third component).

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or tentatively generated in a machine-readable recording medium, such as a memory of a manufacturer's server, an application store's server, or a relay server.

According to the embodiments disclosed in this document, each of the components (e.g., modules or programs) described above may include a single or plurality of entities, and some of the plurality of entities may be separated and placed in other components. According to the embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by being added with one or more other operations.

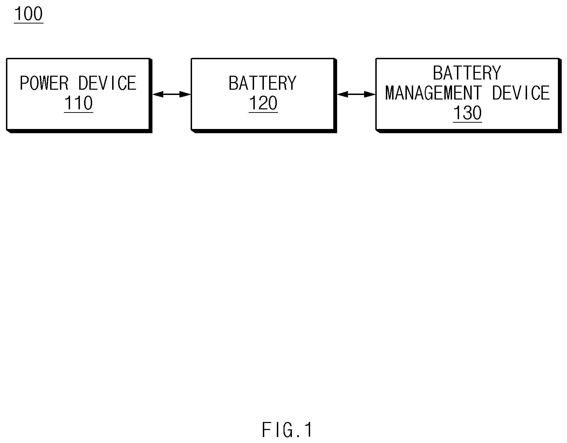

FIG. 1 illustrates components constituting a battery system according to some embodiments.

Referring to FIG. 1, a battery system 100 may include a power device 110, a battery 120, and a battery management device 130. However, it is not limited thereto, and some components may be omitted from the battery system 100 or other general-purpose components may be further included in the battery system 100.

The power device 110 may be configured to charge or discharge the battery 120. The power device 110 may include a power consumption device and/or a power supply device. The power device 110 may discharge the battery 120 while consuming power, or charge the battery 120 while generating power. According to an embodiment, the power consuming device may include a mobility device such as an electric vehicle (EV), a hybrid electric vehicle (HEV), or an electric bike. The mobility device may also function as a power supply device to charge the battery 120. The mobility device may drive a motor using power from the battery 120 or charge the battery 120 using power generated through regenerative braking. According to an embodiment, the power supply device may include a charger/discharger for charging or discharging the battery 120. The charger/discharger may apply a charging current, a charging voltage, a discharging current, and/or a discharging voltage to the battery 120 based on a given profile or cycle.

The battery 120 may include one or more battery packs, etc. The battery pack of the battery 120 may include a plurality of battery modules, and each battery module may include a plurality of battery cells. According to an embodiment, the battery 120 may be mounted on various types of mobility devices.

The battery management device 130 may perform operations for diagnosing, managing, and/or controlling the battery 120. The battery management device 130 may acquire battery data of the battery 120, diagnose or manage a state of the battery 120 based on the battery data, and control an output or charging/discharging of the battery 120. According to an embodiment, the battery management device 130 may include a battery management system (BMS) configured with the battery 120 in an on-board manner, and/or an external device remotely positioned with the battery 120 in an off-board manner. The external device may include a charger of a battery charging station, a battery diagnosis device, a cloud computing server, etc.

The battery system 100 may further include a management server. The management server may manage a management result of the battery management device 130. The management server may exchange data with the battery management device 130 in a wired/wireless communication method. When the battery 120 is diagnosed as defective or its lifespan is predicted, the results may be transmitted to the management server and recorded in a database. According to an embodiment, the battery management device 130 may perform diagnosis operations by executing battery management software, and the management server may provide update information of the battery management software to the battery diagnosis device 130.

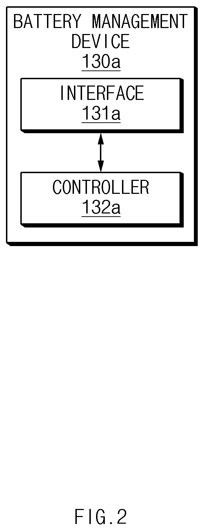

FIG. 2 illustrates components constituting a first battery management device according to some embodiments.

Referring to FIG. 2, a first battery management device 130a may include an interface 131a and a controller 132a. However, it is not limited thereto, and some components may be omitted from the battery management device 130, or other general-purpose components may be further included in the battery management device 130. The first battery management device 130a may be an example of the battery management device 130 of the battery system 100 illustrated in FIG. 1.

The interface 131a may acquire battery data of the battery 120. According to an embodiment, the interface 131a may include a communication unit configured to receive battery data and/or a sensor unit configured to measure battery data. According to an embodiment, when the first battery management device 130a is implemented in an off-board form, the communication unit may receive battery data through wired data communication, wireless data communication, etc. Alternatively, when the first battery management device 130a is implemented in an on-board form, the sensor unit may be configured to measure values such as a voltage, a current, a temperature, a resistance, etc. from the battery 120.

The controller 132a may have a structure for executing instructions that implement operations of the battery management device 130a. The controller 132a may be implemented as an array of multiple logic gates or a general-purpose microprocessor for processing various operations, and may be composed of a single processor or multiple processors. For example, the controller 132 may be implemented in the form of at least one of a microprocessor, a CPU, a GPU, and an AP.

The controller 132a may operate with a memory configured to store various data, instructions, mobile applications, computer programs, etc. The memory may be configured separately from or integrated with the controller 132a. The controller 132a may process various operations by executing instructions stored in the memory. For example, the memory may be implemented as a non-volatile device such as ROM, PROM, EPROM, EEPROM, flash memory, PRAM, MRAM, RRAM, FRAM, etc., or a volatile device such as DRAM, SRAM, SDRAM, PRAM, etc., and may be implemented in the form of an HDD, SSD, SD, Micro-SD, etc., or in the form of a combination thereof.

The interface 131a may be configured to acquire battery data of the battery 120 having a composite negative electrode based on a first active material of a silicon series and a second active material of a graphite series. The composite negative electrode may further include graphite to solve a problem in which a volume change of silicon occurs due to charging and discharging. For example, a weight ratio of the first active material of a silicon series and the second active material of a graphite series in the composite negative electrode may be 6:94, and a specific value of the weight ratio may vary depending on a design change. According to an embodiment, the interface 131a may include a communication unit configured to receive battery data and/or a sensor unit configured to measure the battery data. According to an embodiment, when the first battery management device 130a is implemented in an off-board form, the communication unit may receive battery data through wired data communication, wireless data communication, etc. Alternatively, when the first battery management device 130a is implemented in an on-board form, the sensor unit may be configured to measure values such as a voltage, a current, a temperature, a resistance, etc. from the battery 120. According to an embodiment, the battery data may include charging data related to charging of the battery 120 and/or discharging data related to discharging thereof. For example, the charging data and/or the discharging data may include current data, voltage data, temperature data, capacity data, resistance data, and/or degradation data.

The controller 132a may be configured to calculate a first negative electrode capacity of the first active material, a second negative electrode capacity of the second active material, and a total negative electrode capacity of the composite negative electrode based on the battery data. For example, the total negative electrode capacity of the composite negative electrode may be measured in units of Ah, and may be calculated based on the charging/discharging current and charging/discharging time of the composite negative electrode. A first negative electrode capacity of the first active material and a second negative electrode capacity of the second active material may be estimated based on a charging voltage profile or a discharging voltage profile. For example, a first charging voltage profile of a negative electrode containing only a first active material and a second charging voltage profile of a negative electrode containing only a second active material may be prepared in advance through an experiment, and a content ratio and/or negative electrode capacity contribution ratio of the first active material and the second active material may be estimated by comparing a charging voltage profile of the composite negative electrode with the first and second charging voltage profiles by a data interpolation method after measuring the charging voltage profile of the composite negative electrode. For example, the charging voltage profile may indicate a variation in charging voltage depending on the charging capacity, and machine learning models trained to compare the charging voltage profiles may be used. When the content ratio and/or negative electrode capacity contribution ratio of the first active material and the second active material are estimated, the first negative electrode capacity and the second negative electrode capacity may be determined therefrom.

The controller 132a may be configured to diagnose a state of the composite negative electrode based on a first capacity ratio of the first negative electrode capacity to the total negative electrode capacity and a second capacity ratio of the second negative electrode capacity to the total negative electrode capacity. The state of the composite negative electrode may vary depending on a degradation level of the first active material of a silicon series and/or second active material, and the degradation level may be determined based on the first capacity ratio and the second capacity ratio. When a structure change such as particle cracking, a solid electrolyte interphase (SEI) layer formation, etc. occur in the first active material, the overall performance of the composite negative electrode may be degraded, which may be diagnosed as a degraded state. When the state of the composite negative electrode is diagnosed, the first battery management device 130a may perform various additional actions based on this. For example, circuit opening, grounding, output limitation, performance limitation, use time limitation, etc. of the battery 120 may be performed, and warnings or notifications to a user of the battery 120 and/or the power device 110 may be performed through a registered terminal device of the user.

According to an embodiment, the controller 132a may be configured to diagnose the state of the composite negative electrode based on a variation in the first capacity ratio and the second capacity ratio according to an increase in the number of charging/discharging times of the battery 120. Since a variation pattern of the first capacity ratio and the second capacity ratio may vary depending on a degradation state of the composite negative electrode, the state of the composite negative electrode may be diagnosed by tracking the variation pattern according to the increase in the number of charging/discharging times.

According to an embodiment, the controller 132a may be configured to diagnose the composite negative electrode such that the degradation of the first negative electrode capacity is smaller than the degradation of the second negative electrode capacity when a first trend in which the first capacity ratio increases while the second capacity ratio decreases is maintained as the number of charging/discharging times of the battery 120 increases. When a use environment of the battery 120 mainly causes the degradation of graphite, graphite main degradation corresponding to a situation, in which the degradation of the first negative electrode capacity is smaller than the degradation of the second negative electrode capacity, may occur. In the graphite main degradation, the first capacity ratio may continuously increase, and the second capacity ratio may continuously decrease. As a result of the measurement, when such a pattern is confirmed, the state of the composite negative electrode of the battery 120 may be diagnosed as graphite main degradation in progress.

According to an embodiment, the controller 132a may be configured to diagnose the composite negative electrode such that the degradation of the first negative electrode capacity is greater than the degradation of the second negative electrode capacity when the first trend transitions to a second trend in which the first capacity ratio decreases while the second capacity ratio increases. When the use environment of the battery 120 mainly causes degradation of silicon, silicon main degradation in which the first trend transitions to the second trend may occur. In the silicon main degradation, stage 1 in which a surface area of the active material increases due to particle cracking may progress, and when the degradation continues, stage 1 may progress to stage 2 in which the SEI layer is formed. In stage 2, an expression capacity of silicon may decrease due to the SEI layer, which may cause a second trend in which the second capacity ratio increases while the first capacity ratio decreases. As a result of the measurement, when a pattern in which the first trend transitions to the second trend is confirmed, the state of the composite negative electrode of the battery 120 may be diagnosed as silicon main degradation in progress.

According to an embodiment, when the first trend transitions to the second trend, the controller 132a may be configured to diagnose the composite negative electrode as having progressed through a crystalline degradation stage and amorphous degradation stage of the first active material. The crystalline degradation stage may mean stage 1 in which the surface area of the active material increases due to particle cracking, and the amorphous degradation stage may mean stage 2 in which the expression capacity of silicon decreases due to the formation of the SEI layer.

According to an embodiment, the controller 132a may be configured to estimate a progress rate of the crystalline degradation stage and a progress rate of the amorphous degradation stage based on a ratio between the first capacity ratio and the second capacity ratio when the first trend transitions to the second trend. For example, a time point at which the increasing first capacity ratio starts to decrease may be a time point at which the first trend transitions to the second trend, and at this time point, the progress of the crystalline degradation stage may be completed and the amorphous degradation stage may start. In consideration of this, the progress rate of the amorphous degradation stage may be estimated based on a decrease amount of the first capacity ratio after the first trend transitions to the second trend.

According to an embodiment, the controller 132a may be configured to diagnose that lithium precipitation occurs in the composite negative electrode when the first trend is maintained, and diagnose that side reaction gas occurs in the composite negative electrode when the first trend transitions to the second trend. The maintenance of the first trend may be determined as graphite main degradation, and the graphite main degradation may cause lithium precipitation inside the composite negative electrode. On the other hand, the transition of the first trend to the second trend may be determined as silicon main degradation, the silicon main degradation may cause a side reaction of the battery in the process of forming the SEI layer, and the side reaction of the battery may cause gas generation. In consideration of these, lithium precipitation or side reaction gas generation may be diagnosed based on whether the transition to the second trend occurs. According to an embodiment, an amount of lithium precipitation and/or an amount of side reaction gas generation may be estimated based on the progress degree of the first trend and/or the second trend.

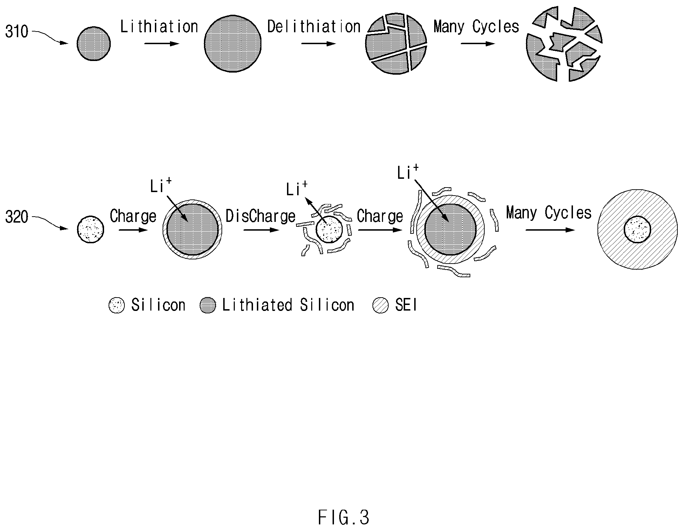

FIG. 3 illustrates a form in which a structure of a silicon series degrades due to charging and discharging according to some embodiments.

Referring to FIG. 3, a crystalline degradation stage 310 and an amorphous degradation stage 320 illustrating a form in which a structure of a silicon series is degraded due to charging and discharging may be illustrated.

In the crystalline degradation stage 310, particle cracking may occur as the lithiation and delithiation of the active material particles are repeated, and as a result, the surface area of the active material may increase and the negative electrode capacity expression of the silicon active material may increase.

In the amorphous degradation stage 320, the degradation may further progress as the charging and discharging are repeated, and as a result, an unstable SEI layer may be formed. The SEI layer may impede the transport of lithium ions, which may reduce the negative electrode capacity expression of the silicon active material.

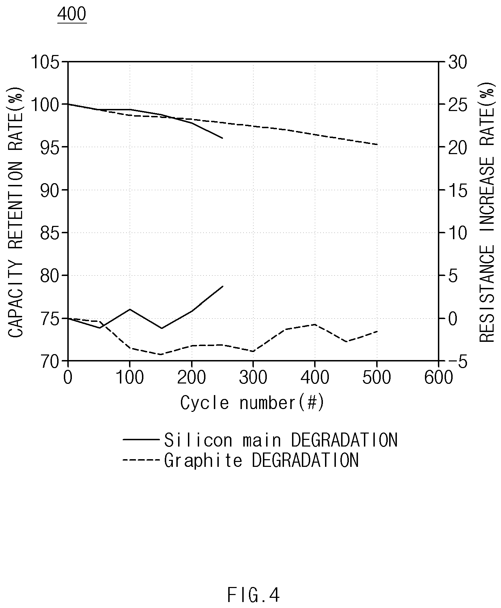

FIG. 4 illustrates silicon main degradation and graphite main degradation occurring in a composite negative electrode according to some embodiments.

Referring to FIG. 4, a graph 400 illustrating silicon main degradation and graphite main degradation occurring in a composite negative electrode may be illustrated. The horizontal axis of the graph 400 may represent the number of charging/discharging cycles, and the vertical axis of the graph 400 may represent the resistance increase rate and the capacity retention rate.

As in the graph 400, when the silicon main degradation progresses, the increase in battery resistance may be accelerated from about 200 cycles, whereas when the graphite main degradation progresses, the increase in battery resistance may be gradual. In addition, as in the graph 400, in the case of graphite main degradation, the capacity retention rate may decrease gradually, whereas in the case of silicon main degradation, the decrease in the capacity retention rate may be accelerated from about 200 cycles.

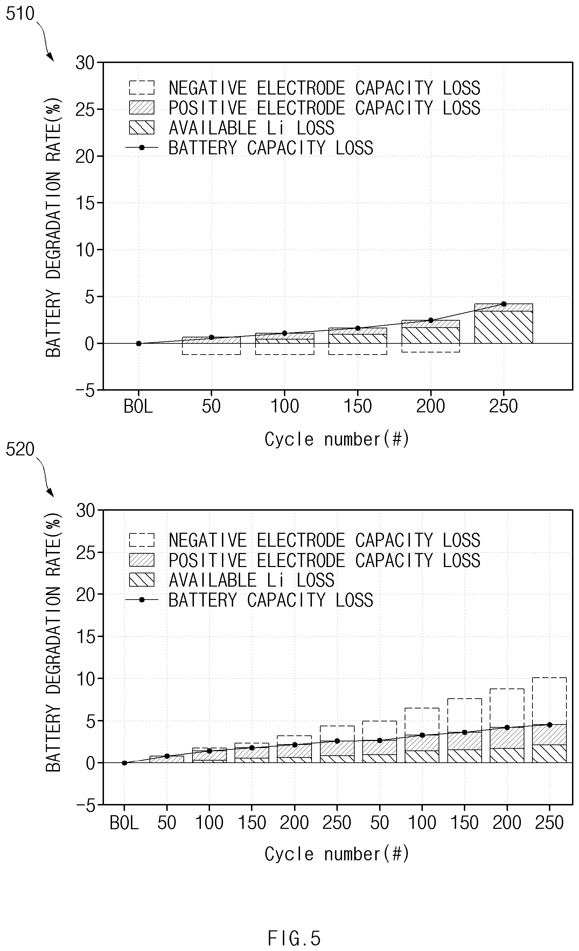

FIG. 5 illustrates a degradation behavior of silicon main degradation and a degradation behavior of graphite main degradation according to some embodiments.

Referring to FIG. 5, a graph 510 illustrating the degradation behavior of silicon main degradation and a graph 520 illustrating the degradation behavior of graphite main degradation may be illustrated. The horizontal axes of the graph 510 and the graph 520 may represent the number of charging/discharging cycles, and the vertical axes of the graph 510 and the graph 520 may represent battery degradation and/or capacity loss.

As in the graph 510, when the silicon main degradation progresses, loss of available lithium may be identified as the most major degradation. On the other hand, as in the graph 520, when the graphite main degradation progresses, loss of the negative electrode capacity may be identified as the most major degradation.

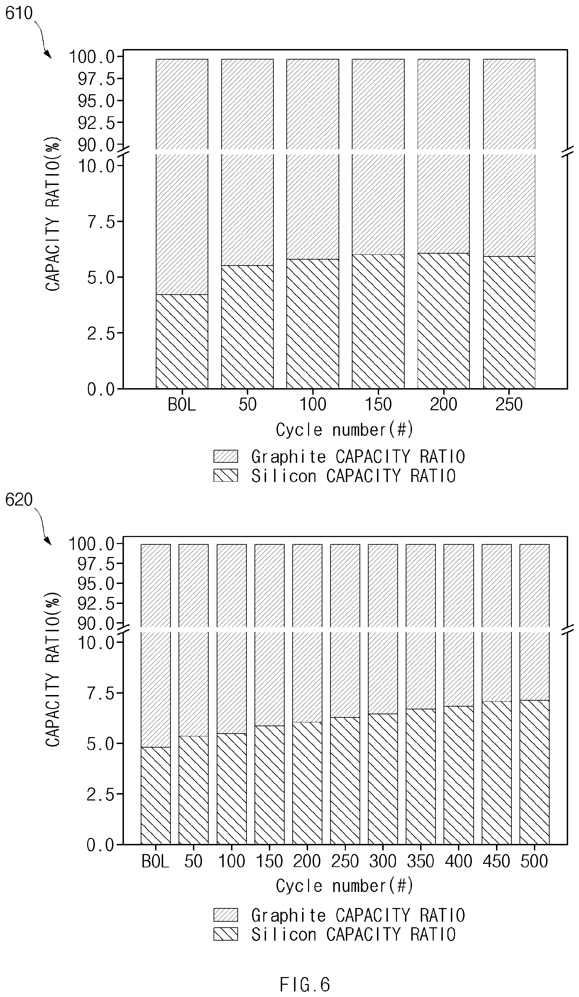

FIG. 6 illustrates a degradation indicator used to diagnose a progress state of silicon main degradation according to some embodiments.

Referring to FIG. 6, graphs 610 and 620 illustrating degradation indicators used to diagnose a progress state of silicon main degradation may be illustrated. In the graph 610 and the graph 620, the horizontal axes may represent the number of charging/discharging cycles and the vertical axes may represent the capacity ratio.

In the case of the first battery management device 130a, the degradation indicators may be a first capacity ratio of the first active material and a second capacity ratio of the second active material relative to the total negative electrode capacity of the composite negative electrode. In the graph 610 and the graph 620, the total negative electrode capacity of the composite negative electrode may always be converted to 100, and the first capacity ratio and the second capacity ratio may be calculated for this. Here, the sum of the first capacity ratio and the second capacity ratio may be 100.

As in the graph 620, in the case of graphite main degradation, as the charging/discharging cycles progresses, the first capacity ratio may continuously increase and the second capacity ratio may continuously decrease. On the other hand, as in the graph 610, in the case of silicon main degradation, a first trend in which the second capacity ratio decreases while the first capacity ratio increases may first appear, and the first trend may transition to the second trend at a specific time point. The transition to the second trend may indicate that the crystalline degradation stage of the silicon active material has progressed to the amorphous degradation stage.

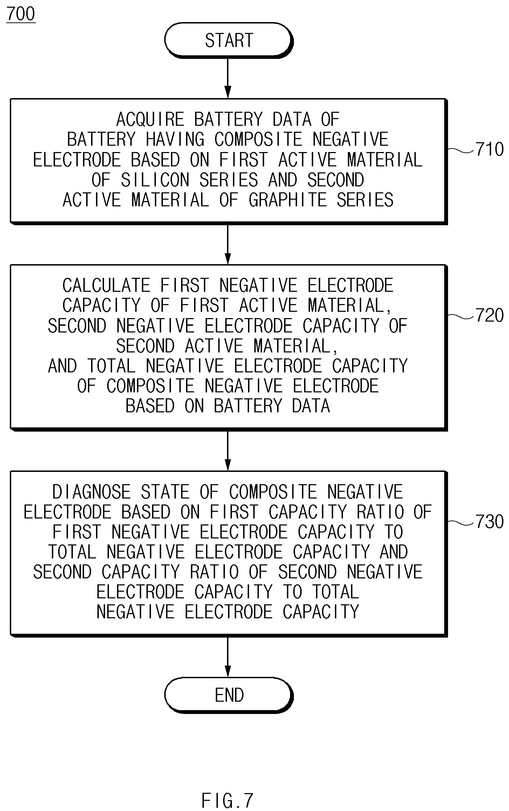

FIG. 7 illustrates steps constituting a first battery management method according to some embodiments.

Referring to FIG. 7, a first battery management method 700 may include steps 710 to 730. However, it is not limited thereto, and some steps may be omitted or other general-purpose steps may be added, and the steps of the first battery management method 700 may be executed in an order different from the order shown.

The first battery management method 700 may include steps processed in time series by the first battery management device 130a. Therefore, even if the content is omitted below, the content described above for the first battery management device 130a may be equally applied to the first battery management method 700.

Steps 710 to 730 of the first battery management method 700 may be performed by the interface 131a and the controller 132a of the first battery management device 130a.

In step 710, the first battery management device 130a may perform a step of acquiring battery data of a battery having a composite negative electrode based on a first active material of a silicon series and a second active material of a graphite series.

In step 720, the first battery management device 130a may perform a step of calculating a first negative electrode capacity of the first active material, a second negative electrode capacity of the second active material, and a total negative electrode capacity of the composite negative electrode based on the battery data.

In step 730, the first battery management device 130a may diagnose the state of the composite negative electrode based on a first capacity ratio of the first negative electrode capacity to the total negative electrode capacity and a second capacity ratio of the second negative electrode capacity to the total negative electrode capacity.

According to an embodiment, the first battery management method 700 may be implemented in the form of a computer program stored in a computer-readable storage medium. That is, the computer program may include instructions for implementing the first battery management method 700, and the instructions of the program may be stored in the computer-readable storage medium. The computer program may include a mobile application.

According to an embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language code generated by a compiler and high-level language code executable by a computer using an interpreter, etc.

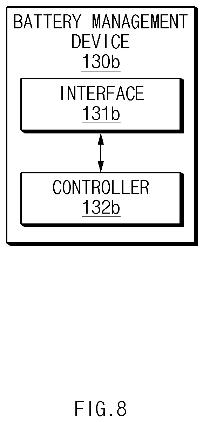

FIG. 8 illustrates components constituting a second battery management device according to some embodiments.

Referring to FIG. 8, a second battery management device 130b may include an interface 131b and a controller 132b. However, it is not limited thereto, and some components may be omitted from the second battery management device 130b, or other general-purpose components may be further included in the second battery management device 130b. The second battery management device 130b may be an example of the battery management device 130 of the battery system 100 illustrated in FIG. 1.

The first battery management device 130a may diagnose the state of the composite negative electrode based on a capacity ratio of the first active material and a capacity ratio of the second active material, whereas the second battery management device 130b may diagnose the state of the composite negative electrode based on loading of the negative electrode of the first active material and loading of the negative electrode of the second active material.

The interface 131b of the second battery management device 130b may be substantially identical to the interface 131a of the first battery management device 130a. The interface 131b may be configured to acquire battery data of a battery having a composite negative electrode based on a first active material of a silicon series and a second active material of a graphite series. Meanwhile, the structure of the controller 132b of the second battery management device 130b may be substantially identical to the structure of the controller 132a of the first battery management device 130a.

The controller 132b may be configured to calculate a first negative electrode loading of the first active material for the composite negative electrode and a second negative electrode loading of the second active material for the composite negative electrode based on the battery data. For example, negative electrode loading may be measured by dividing a negative electrode capacity by a negative electrode area. A first negative electrode capacity and a second negative electrode capacity may be measured in the same manner as in the first battery management device 130a, and the first negative electrode loading and the second negative electrode loading may be calculated by dividing the first negative electrode capacity and the second negative electrode capacity by the area of the composite negative electrode. For example, the negative electrode capacity may be obtained in units of mAh, the negative electrode area coated with the active material may be obtained in units of cm² units, and the negative electrode loading may be obtained in units of mAh/cm². The negative electrode loading may be the capacity density of the negative electrode active material formed on a negative electrode plate. For the same negative electrode area, the higher the negative electrode loading, the higher the capacity of the negative electrode active material may be.

The controller 132b may be configured to diagnose the state of the composite negative electrode based on the first negative electrode loading and the second negative electrode loading. The state of the composite negative electrode may vary depending on the degradation level of the first active material of a silicon series and/or the second active material, and the degradation level may be determined based on the first negative electrode loading and the second negative electrode loading. When a structure change such as particle cracking or SEI layer formation occurs in the first active material, the overall performance of the composite negative electrode may be degraded, which may be diagnosed as a degraded state. When the state of the composite negative electrode is diagnosed, the second battery management device 130b may perform various additional actions based on this. For example, circuit opening, grounding, output limitation, performance limitation, use time limitation, etc. of the battery 120 may be performed, and warnings or notifications to a user of the battery 120 and/or the power device 110 may be performed through a registered terminal device of the user.

According to an embodiment, the controller 132b may be configured to diagnose the state of the composite negative electrode based on a variation in the first negative electrode loading and the second negative electrode loading according to an increase in the number of charging/discharging times of the battery 120. Since the variation pattern of the first negative electrode loading and the second negative electrode loading may vary depending on the degradation state of the composite negative electrode, the state of the composite negative electrode may be diagnosed by tracking the variation pattern according to the increase in the number of charging and discharging times.

According to an embodiment, the controller 132b may be configured to diagnose the composite negative electrode such that the degradation of the first active material is smaller than the degradation of the second active material when the first trend, in which the first negative electrode loading increases while the second negative electrode loading decreases, is maintained as the number of charging/discharging times of the battery 120 increases. When the use environment of the battery 120 mainly causes the degradation of graphite, the main degradation of graphite corresponding to a situation, in which the degradation of the first negative electrode capacity is smaller than the degradation of the second negative electrode capacity, may occur. In the graphite main degradation, the first negative electrode loading may continuously increase and the second negative electrode loading may continuously decrease. As a result of the measurement, when such a pattern is confirmed, the state of the composite negative electrode of the battery 120 may be diagnosed as graphite main degradation in progress.

According to an embodiment, the controller 132b may be configured to diagnose the composite negative electrode such that the degradation of the first active material is greater than the degradation of the second active material when the first trend transitions to the second trend in which the first negative electrode loading decreases while the second negative electrode loading decreases. When the use environment of the battery 120 mainly causes degradation of silicon, silicon main degradation in which the first trend transitions to the second trend may occur. In the silicon main degradation, stage 1 in which the surface area of the active material increases due to particle cracking may progress, and when the degradation continues, stage 1 may progress to stage 2 in which the SEI layer is formed. In stage 2, the expression capacity of silicon may decrease due to the SEI layer, which may cause the second trend in which the first negative electrode loading decreases. Meanwhile, unlike the case of the capacity ratio of the first battery management device 130a, the second negative electrode loading in the second trend may be reduced to a negligible level. As a result of the measurement, when a pattern in which the first trend transitions to the second trend is confirmed, the state of the composite negative electrode of the battery 120 may be diagnosed as silicon main degradation in progress.

According to an embodiment, when the first trend transitions to the second trend, the controller 132b may be configured to diagnose the composite negative electrode as having progressed through the crystalline degradation stage and the amorphous degradation stage of the first active material. The crystalline degradation stage may mean stage 1 in which the surface area of the active material increases due to particle cracking, and the amorphous degradation stage may mean stage 2 in which the expression capacity of silicon decreases due to the formation of the SEI layer.

According to an embodiment, when the first trend transitions to the second trend, the controller 132b may be configured to estimate a progress rate of the crystalline degradation stage and a progress rate of the amorphous degradation stage based on the first negative electrode loading and the second negative electrode loading. For example, a time point at which the increasing first negative electrode loading starts to decrease may be a time point at which the first trend transitions to the second trend, and at this time point, the progress of the crystalline degradation stage may be completed and the amorphous degradation stage may start. In consideration of this, a progress rate of the amorphous degradation stage may be estimated based on a decrease amount of the first negative electrode loading after the first trend transitions to the second trend.

According to an embodiment, the controller 132b may be configured to diagnose that lithium precipitation occurs in the composite negative electrode when the first trend is maintained, and diagnose that side reaction gas occurs in the composite negative electrode when the first trend transitions to the second trend. The maintenance of the first trend may be determined as graphite main degradation, and the graphite main degradation may cause lithium precipitation inside the composite negative electrode. On the other hand, the transition of the first trend to the second trend may be determined as silicon main degradation, the silicon main degradation may cause a battery side reaction during the formation of the SEI layer, and the battery side reaction may cause gas generation. In consideration of these, lithium precipitation or side reaction gas generation may be diagnosed based on whether a transition to the second trend occurs. According to an embodiment, the amount of lithium precipitation and/or the amount of side reaction gas generation may be estimated based on a progress degree of the first trend and/or the second trend.

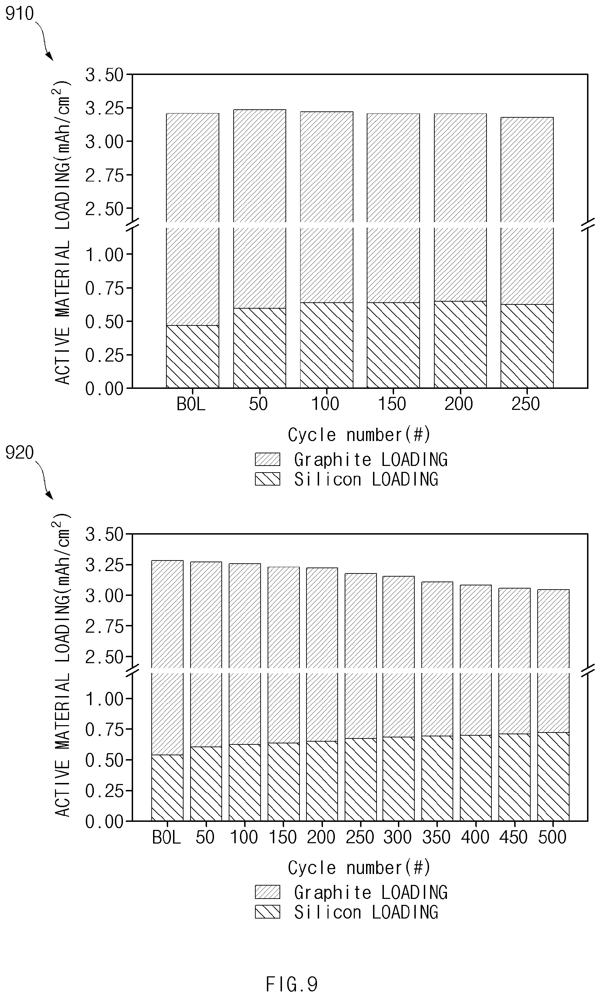

FIG. 9 illustrates degradation indicators used to diagnose a progress state of silicon main degradation according to some embodiments.

Referring to FIG. 9, a graph 910 and a graph 920 illustrating indicators used to diagnose a progress state of silicon main degradation may be illustrated. In the graph 910 and the graph 920, the horizontal axis may represent the number of charging/discharging cycles and the vertical axis may represent the active material negative electrode loading.

In the case of the second battery management device 130b, the degradation indicators may be a first negative electrode loading for the composite negative electrode of the first active material and a second negative electrode loading for the composite negative electrode of the second active material. Unlike the graph 610 and the graph 620 of FIG. 6 in which the total negative electrode capacity of the composite negative electrode is always maintained at 100, in the graph 910 and the graph 920, the total amount of the first negative electrode loading and the second negative electrode loading may continuously vary depending on the number of charging/discharging cycles.

As in the graph 920, in the case of graphite main degradation, as the charging/discharging cycles progress, the first negative electrode loading may continuously increase and the second negative electrode loading may continuously decrease. On the other hand, as in the graph 920, in the case of the silicon main degradation, first, a first trend in which the first negative electrode loading increases while the second negative electrode loading decreases may appear, and the first trend may transition to the second trend at a specific time point. The transition to the second trend may indicate that the crystalline degradation stage of the silicon active material has progressed to the amorphous degradation stage.

Meanwhile, the contents described for the first battery management device 130a in FIGS. 3 to 5 may be equally applied to the second battery management device 130b.

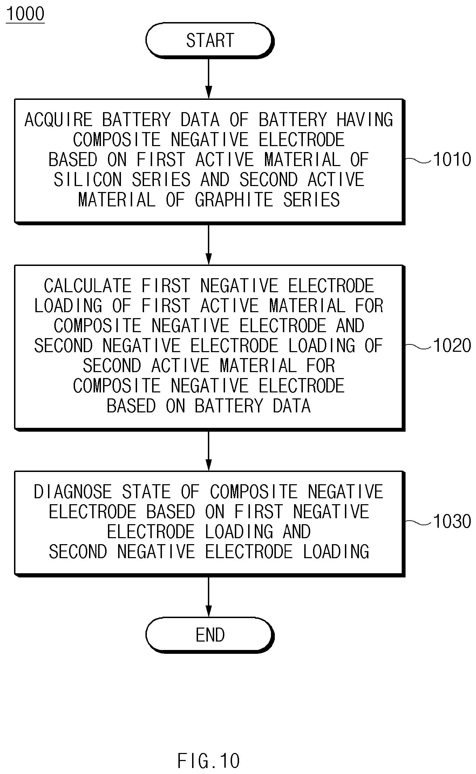

FIG. 10 illustrates steps constituting a second battery management method according to some embodiments.

Referring to FIG. 10, a second battery management method 1000 may include steps 1010 to 1030. However, it is not limited thereto, and some steps may be omitted or other general-purpose steps may be added, and the steps of the second battery management method 1000 may be executed in an order different from the order shown.

The second battery management method 1000 may include steps that are processed in time series by the second battery management device 130b. Accordingly, even if the content is omitted below, the content described above for the second battery management device 130b may be equally applied to the second battery management method 1000.

Steps 1010 to 1030 of the second battery management method 1000 may be performed by the interface 131b and the controller 132b of the second battery management device 130b.

In step 1010, the second battery management device 130b may perform a step of acquiring battery data of a battery having a composite negative electrode based on a first active material of a silicon series and a second active material of a graphite series.

In step 1020, the second battery management device 130b may perform a step of calculating first negative electrode loading of a first active material for the composite negative electrode and second negative electrode loading of a second active material for the composite negative electrode based on the battery data.

In step 1030, the second battery management device 130b may perform a step of diagnosing a state of the composite negative electrode based on the first negative electrode loading and the second negative electrode loading.

According to an embodiment, the second battery management method 1000 may be implemented in the form of a computer program stored in a computer-readable storage medium. That is, the computer program may include instructions for implementing the second battery management method 1000, and the instructions of the program may be stored in the computer-readable storage medium. The computer program may include a mobile application.

According to an embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language code generated by a compiler and high-level language code executable by a computer using an interpreter, etc.

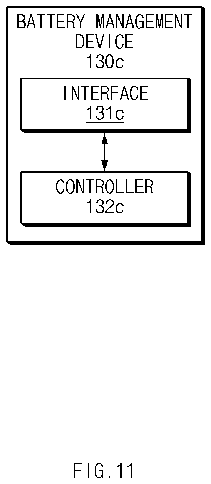

FIG. 11 illustrates components constituting a third battery management device according to some embodiments.

Referring to FIG. 11, a third battery management device 130c may include an interface 131c and a controller 132c. However, it is not limited thereto, and some components may be omitted from the third battery management device 130c, or other general-purpose components may be further included in the second battery management device 130c. The third battery management device 130c may be an example of the battery management device 130 of the battery system 100 illustrated in FIG. 1.

The interface 131c of the third battery management device 130c may be substantially identical to the interface 131a of the first battery management device 130a and/or the interface 131b of the second battery management device 130b. The interface 131c may be configured to acquire battery data of a battery having a composite negative electrode based on a first active material of a silicon series and a second active material of a graphite series. Meanwhile, the structure of the controller 132c of the third battery management device 130c may be substantially identical to the structure of the controller 132a of the first battery management device 130a and/or the controller 132b of the second battery management device 130b.

The controller 132c may be configured to generate a charging voltage profile representing a variation in voltage according to a variation in charging capacity of the composite negative electrode based on the battery data. The charging capacity of the battery 120 may be calculated based on a charging/discharging current and a charging/discharging time of the battery 120, and a charging voltage profile of the battery 120 may be generated based on the charging capacity and voltage. The charging voltage profile of the composite negative electrode may be estimated based on the charging voltage profile of the battery 120. For example, the charging voltage profiles of the entire battery and the charging voltage profiles of the composite negative electrode may be prepared through experiments and/or simulations, and a machine learning model that defines a relationship between the profile of the entire battery and the profile of the composite negative electrode may be trained using these charging voltage profiles as training data. The trained model may estimate the charging voltage profile of the composite negative electrode based on the charging voltage profile of the battery 120.

The controller 132c may be configured to divide an entire section of the charging capacity into a plurality of charging stages based on a variation pattern of the charging voltage profile. For example, the charging voltage profile may be estimated in the form of a curve on a two-dimensional plane having a horizontal axis of a charging capacity and a vertical axis of a voltage, and a plurality of charging stages may be distinguished based on a variation pattern of the two-dimensional curve. The entire section of the charging capacity may be a section from a fully discharged state to a fully charged state on the horizontal axis of the two-dimensional plane, and boundary values for distinguishing) the corresponding section may be set. The boundary values may be set based on a variation pattern such as a slope of a two-dimensional curve or a quadratic derivative coefficient. As the degradation of the composite negative electrode progresses, the shape of the charging voltage profile may also be changed, and thus the boundary values for distinguishing the plurality of charging stages may also be changed.

The controller 132c may be configured to estimate a swelling profile representing a variation in swelling of the battery 120 according to a variation in charging capacity by applying the first charging behavior profile of the first active material and the second charging behavior profile of the second active material, which indicate a variation in state of charge (SOC) according to the variation in charging capacity, to the plurality of charging stages. The first charging behavior profile of the first active material and the second charging behavior profile of the second active material may be prepared in advance through experiments and/or simulations. For example, for a composite negative electrode having a weight ratio of silicon and graphite of 6:94, a first charging behavior profile and a second charging behavior profile which indicate SOC variation according to charging capacity may be measured. The first charging behavior profile and the second charging behavior profile may be applied to a plurality of charging stages on a section-by-section basis. Swelling behavior such as increased pressure and/or thickness in the battery cell may correspond to the charging behavior profile of the composite negative electrode, and the swelling profile may be estimated using this.

Meanwhile, the swelling profile is illustrated as being estimated based on the charging voltage profile, but alternatively, a discharging voltage profile may be generated in a manner similar to the charging voltage profile, and a method of estimating the swelling profile based on the discharging voltage profile may also be used.

According to an embodiment, the plurality of charging stages may include a plurality of expansion stages that occurs due to intercalation of lithium ions into the second active material as the charging capacity increases. The second active material of the graphite series may have a layered structure with respect to a plurality of layers, and when the charging capacity increases while the battery 120 is being charged, lithium ions may be intercalated between the plurality of layers. As the intercalation of lithium ions progresses, an interlayer distance of the second active material may increase, and accordingly, the volume of the second active material and the composite negative electrode may expand. Volume expansion may be divided into a plurality of expansion stages according to the progress level of the intercalation. For example, when the maximum charging capacity of the battery 120 is about 7 Ah, a charging capacity section of 0 Ah to 7 Ah may be divided into stages 1 to 4.

According to an embodiment, the battery 120 may further include an NCM positive electrode including nickel, cobalt, and manganese, and the plurality of charging stages may further include a contraction stage that occurs due to a phase transition of the NCM positive electrode. The positive electrode material of the NCM positive electrode may include lithium cobalt oxide (LCO), nickel (Ni), and manganese (Mn). In the case of the NCM positive electrode, a phase transition from a H2 phase to a H3 phase may occur in the latter half of the charging capacity as it approaches full charging. During the H2-H3 phase transition process, the volume of the NCM positive electrode may be decrease, which may affect swelling of the entire battery 120 along with the volume expansion of the composite negative electrode. For example, H2-H3 phase transition may occur in stage 1, which corresponds to the latter half of the charging capacity section, and as a result, local minimum, in which swelling of the battery 120 temporarily decreases and then increases again, may be formed in stage 1.

According to an embodiment, the controller 132c may be further configured to compare the current charging capacity of the battery 120 with the plurality of charging stages to estimate the current expansion stage of the composite negative electrode and the current phase transition state of the NCM positive electrode. For example, when the maximum charging capacity of the battery 120 is about 7 Ah, the charging capacity section of 0 Ah to 7 Ah may be divided into stages 1 to 4, and the value of the charging capacity at which the H2→H3 phase transition occurs may be identified based on the local minimum occurring at the latter half of stage 1. Accordingly, when the current charging capacity of the battery 120 is measured, the current state of the composite negative electrode may be estimated based on which charging stage the corresponding value belongs to. In addition, in the case of stage 1 in the latter half of charging, the current phase of the NCM positive electrode may be estimated by comparing the current charging capacity of the battery 120 with the H2-H3 phase transition occurrence capacity.

According to an embodiment, the controller 132c may be configured to divide the entire section of the charging capacity into a plurality of expansion stages based on the slope of the charging voltage profile. As described above, the charging voltage profile may be estimated in the form of a curve on a two-dimensional plane, and a point at which the slope of the two-dimensional curve rapidly varies may be set as a stage boundary. Alternatively, data clustering may be performed based on a slope of a two-dimensional curve and/or a quadratic derivative coefficient, and a plurality of expansion stages may be determined based on the results.

According to an embodiment, the controller 132c may be configured to apply a plurality of charging behavior patterns of the first charging behavior profile to the plurality of charging stages, respectively, and apply a plurality of charging behavior patterns of the second charging behavior profile to the plurality of charging stages, respectively. The swelling profile may be estimated using a portion of the first filling behavior profile and a portion of the second filling behavior profile corresponding to each filling stage. For example, when the charging capacity section of 0 Ah to 7 Ah is divided into four stages, a first charging behavior profile and a second charging behavior profile may also be divided into four sections, and four sections of the swelling profile may be estimated based on a portion of the sections of the first charging behavior profile and a portion of the sections of the second charging behavior profile corresponding to each stage. For example, the swelling profile may be estimated through the application of weights and/or coefficients to the first filling behavior profile and the second filling behavior profile.

According to an embodiment, the controller 132c may be further configured to diagnose the state of the battery 120 by comparing the swelling profile with a swelling threshold. When a value exceeding the swelling threshold is detected in the swelling profile, the degradation state of the battery 120 may be diagnosed as defective. When the swelling state of the battery 120 is diagnosed, the third battery management device 130c may perform various additional actions based on this. For example, circuit opening, grounding, output limitation, performance limitation, use time limitation, etc. of the battery 120 may be performed, and warnings or notifications to a user of the battery 120 and/or the power device 110 may be performed through a registered terminal device of the user.

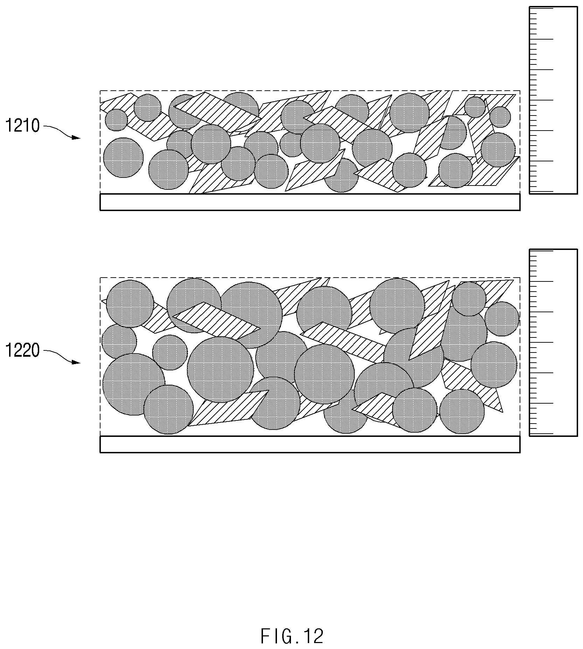

FIG. 12 illustrates a volume change of a composite negative electrode due to charging and discharging according to some embodiments.

Referring to FIG. 12, a discharging state 1210 and a charging state 1220 illustrating the volume change of the composite negative electrode due to charging and discharging may be illustrated.

As illustrated, the volume of the composite negative electrode in the discharging state 1210 may expand as in the charging state 1220 by charging. The volume of the composite cathode may expand due to the phenomenon of lithium ions intercalating between layers of the graphite layered structure. Volume expansion may be measured using various swelling indicators. For example, swelling indicators may include battery pressure, battery thickness, etc.

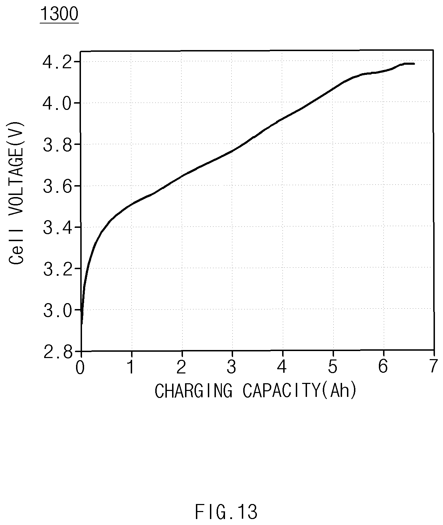

FIG. 13 illustrates a charging voltage profile representing a variation in voltage according to a variation in charging capacity of the entire battery according to some embodiments.

Referring to FIG. 13, a graph 1300 illustrating a charging voltage profile representing a variation in voltage according to a variation in charging capacity of the entire battery 120 may be illustrated. In the graph 1300, the horizontal axis may represent the charging capacity, and the vertical axis may represent the voltage.

The charging voltage profile of the battery 120 may be generated based on battery data such as charging/discharging current, charging/discharging voltage, charging/discharging time, etc. The charging voltage profile of the composite negative electrode may be estimated from the charging voltage profile of the battery 120. The charging voltage profile of the battery 120 may be measured in different forms depending on the degradation state of the battery 120. The degradation state of the battery 120 may be estimated based on how the charging voltage profile of the battery 120 is plotted. For example, the degradation state may include a swelling state of the battery 120.

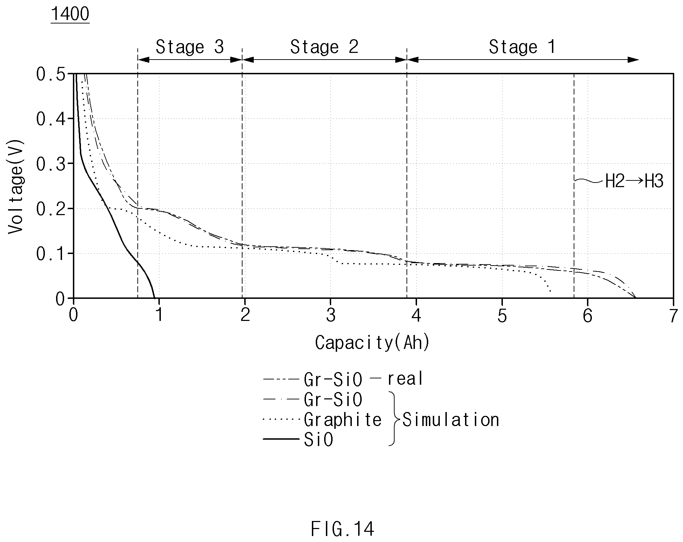

FIG. 14 illustrates a charging voltage profile representing a variation in voltage according to a variation in charging capacity of a composite negative electrode according to some embodiments.

Referring to FIG. 14, a graph 1400 illustrating a charging voltage profile representing a variation in voltage according to a variation in charging capacity of a composite negative electrode may be illustrated. In the graph 1400, the horizontal axis may represent the charging capacity, and the vertical axis may represent the voltage.

The charging voltage profile of the composite negative electrode such as the graph 1400 may be estimated from the charging voltage profile of the entire battery 120 such as the graph 1300 through a method such as training a machine learning model. In the graph 1400, three charging voltage profiles generated through simulation of a composite negative electrode including a first active material of a silicon series, a second active material of a graphite series, and a composite negative electrode including both the first active material and the second active material in combination may be displayed, and a charging voltage profile actually measured through decomposition analysis of the composite negative electrode may be displayed.

The charging voltage profile for the composite negative electrode may be divided into a plurality of charging stages based on the variation pattern of the two-dimensional curve. For example, the entire section of the charging capacity may be divided into stages 1 to 4 based on the slope variation of the two-dimensional curve. Stage 1 in the latter half of charging may include a point at which the H2-H3 phase transition of the NCM positive electrode occurs. The occurrence of the H2-H3 phase transition may also be identified based on the slope variation. As degradation of the battery 120 and/or the composite negative electrode progresses, the shape of the charging voltage profile may be changed, and the boundary values of a plurality of charging stages may also be changed.

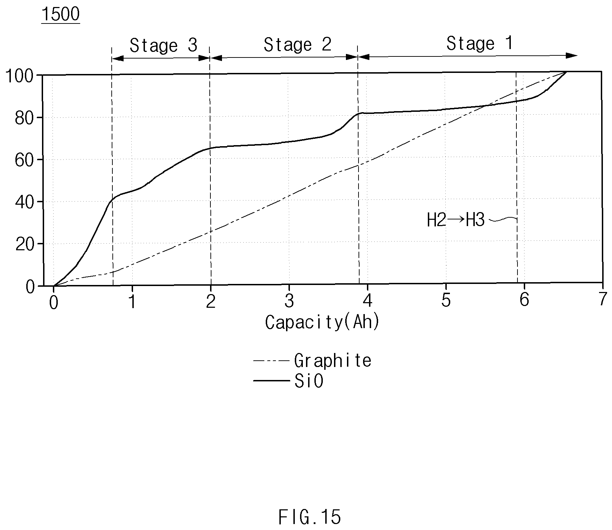

FIG. 15 illustrates a charging behavior of an active material of a silicon series and a charging behavior of active material of a graphite series in a composite negative electrode according to some embodiments.

Referring to FIG. 15, a graph 1500 illustrating a charging behavior of an active material of a silicon series and a charging behavior of active material of a graphite series in a composite negative electrode may be illustrated. In the graph 1500, the horizontal axis may represent the charging capacity, and the vertical axis may represent the state of charge (SOC).

In the graph 1500, the charging behavior of the first active material and the charging behavior of the second active material may be prepared in advance through experiments or simulations. For example, the charging behaviors may be generated differently depending on the composition ratio of the first active material and the second active material, and the composition ratio in the composite negative electrode may be 6:94 by weight, or other appropriate numerical values. The plurality of charging stages displayed in the graph 1500 may be distinguished based on the charging voltage profile for the composite negative electrode of the graph 1400. According to an embodiment, even if the degradation of the battery 120 progresses, the charging behavior of the first active material and the charging behavior of the second active material may not be changed, but since the distinction between the plurality of charging stages may be changed, the swelling profile of the battery 120 may be changed when the charging behavior of the first active material and the charging behavior of the second active material are applied to the changed plurality of charging stages.

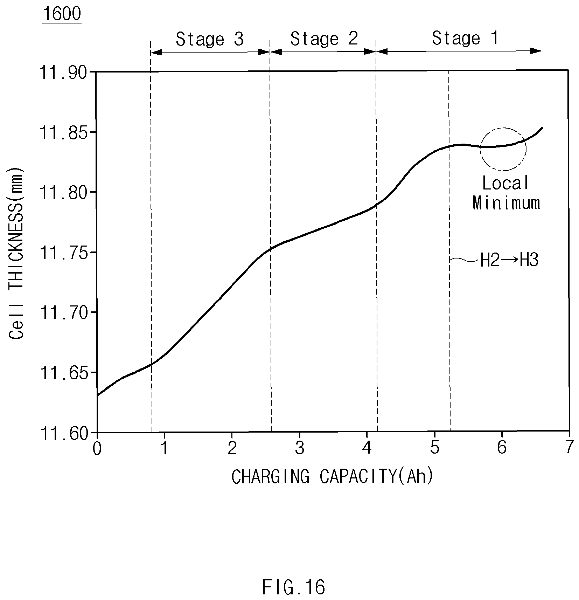

FIG. 16 illustrates a swelling profile illustrating a variation in battery swelling according to a variation in charging capacity according to some embodiments.

Referring to FIG. 16, a graph 1600 illustrating a swelling profile representing a variation in battery swelling according to a variation in charging capacity may be illustrated. In the graph 1600, the horizontal axis may represent the charging capacity, and the vertical axis may represent the battery thickness.

Indicators for indicating a swelling state of the battery 120 may include a battery thickness, an internal pressure of the battery, etc. Although the graph 1600 shows the thickness of the battery, the graph on the internal pressure of the battery may also be measured in a shape similar to the graph 1600. The swelling profile as in the graph 1600 may be estimated by applying the charging behavior of the first active material and the charging behavior of the second active material to the plurality of charging stages. For example, a swelling profile may be estimated by applying weights and/or coefficients to the charging behavior of the first active material and the charging behavior of the second active material. Using the swelling profile, it may be determined whether the swelling state of the battery 120 exceeds a swelling threshold. When the swelling threshold is exceeded, the state of the battery 120 may be diagnosed as defective, and various additional actions may be performed to prevent an accident caused by the defective battery.

At stage 1 of the graph 1600, a H2→H3 phase transition may occur, and thus the volume of the NCM positive electrode of the battery 120 may be reduced. The volume of the composite cathode may be simultaneously affected by the effect of increasing the volume due to intercalation of lithium ions and the effect of decreasing the volume of the NCM cathode, and accordingly, a local minimum of battery swelling may be observed in stage 1. It may be estimated whether the H2→H3 phase transition occurs based on whether the local minimum is observed.

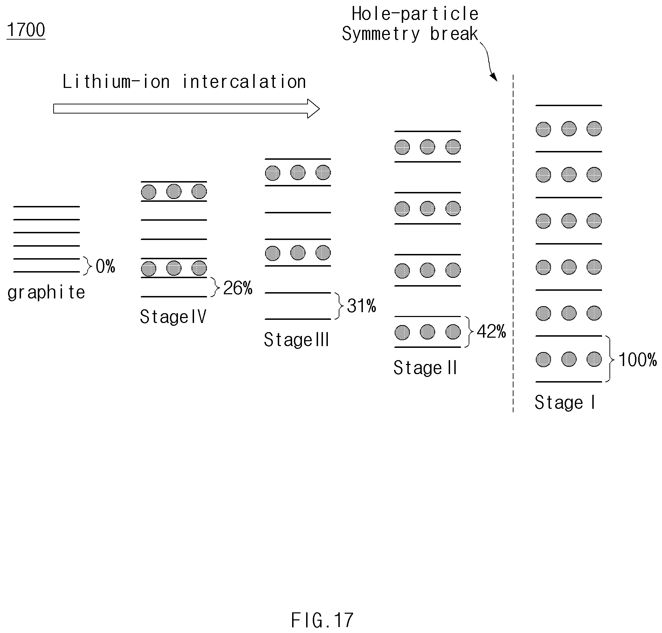

FIG. 17 illustrates stages relating to the structure of graphite that changes during a charging process according to some embodiments.

Referring to FIG. 17, an image 1700 illustrating stages related to the structure of graphite that changes during the charging process may be illustrated.

In the image 1700, an interlayer spacing in a layered structure of graphite may be represented as an exemplary numerical value. For example, the interlayer spacing in a fully discharged state may be 0%, and the interlayer spacing may increase to 26%, 31%, 42%, 100% or the like as the charging stage progresses. The interlayer spacing may increase due to the intercalation of lithium ions, and the interlayer spacing may be increase the most when it reaches stage 1.

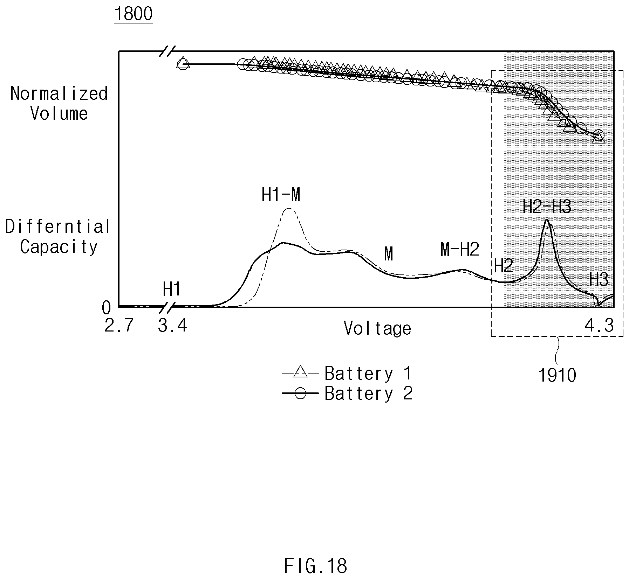

FIG. 18 illustrates phase transition and volume variation of an NCM positive electrode during a charging process according to some embodiments.

Referring to FIG. 18, a graph 1800 illustrating phase transition and volume variation of the NCM positive electrode during the charging process may be illustrated. In the graph 1800, the horizontal axis may represent the voltage, and the vertical axis may represent the differential capacity (dQ/dV) and positive electrode volume.

As in the graph 1800, when the charging of the NCM positive electrode enters the latter half 1910, an H2→H3 phase transition in which the H2 phase transitions to the H3 phase may occur, and thus the volume of the NCM positive electrode may be decrease. The volume decrease of the NCM positive electrode may cause a local minimum of the swelling indicator in stage 1, where the volume of the entire battery 120 temporarily decreases.

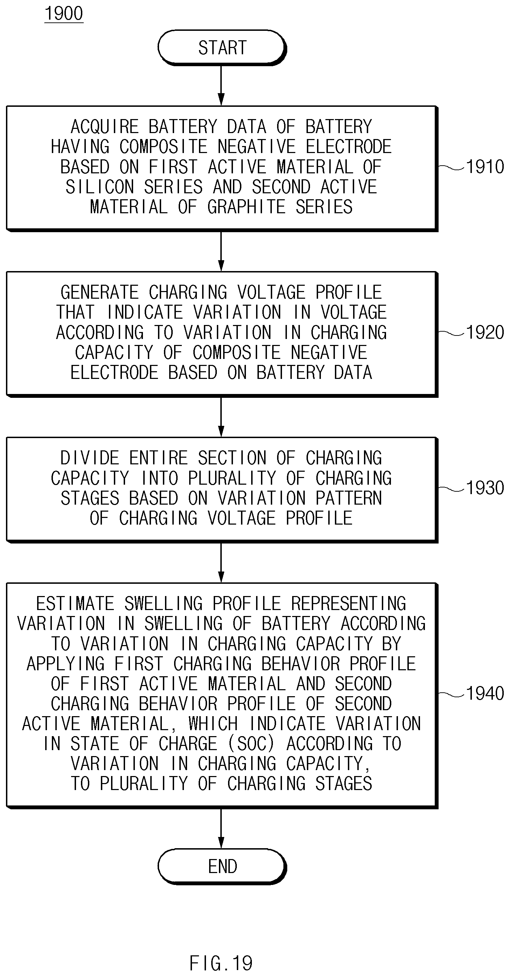

FIG. 19 illustrates steps constituting a third battery management method according to some embodiments.

Referring to FIG. 19, a third battery management method 1900 may include steps 1910 to 1940. However, it is not limited thereto, and some steps may be omitted or other general-purpose steps may be added, and the steps of the third battery management method 1900 may be executed in an order different from the order shown.

The third battery management method 1900 may include steps processed in time series by the third battery management device 130c. Accordingly, even if the content is omitted below, the content described above for the third battery management device 130c may be equally applied to the third battery management method 1900.

Steps 1910 to 1940 of the third battery management method 1900 may be performed by the interface 131c and the controller 132c of the third battery management device 130c.

In step 1910, the third battery management device 130c may perform a step of acquiring battery data of a battery having a composite negative electrode based on a first active material of a silicon series and a second active material of a graphite series.

In step 1920, the third battery management device 130c may perform a step of generating a charging voltage profile that indicates a variation in voltage according to the variation in charging capacity of the composite negative electrode based on the battery data.

In step 1930, the third battery management device 130c may perform a step of dividing the entire section of the charging capacity into a plurality of charging stages based on the variation pattern of the charging voltage profile.

In step 1940, the third battery management device 130c may perform a step of estimating a swelling profile representing a variation in swelling of the battery according to the variation in charging capacity by applying the first charging behavior profile of the first active material and the second charging behavior profile of the second active material, which indicate the variation in the state of charge (SOC) according to the variation in charging capacity, to the plurality of charging stages.

According to an embodiment, the third battery management method 1900 may be implemented in the form of a computer program stored in a computer-readable storage medium. That is, the computer program may include instructions for implementing the third battery management method 1900, and the instructions of the program may be stored in the computer-readable storage medium. The computer program may include a mobile application.

According to an embodiment, the computer-readable storage medium may include magnetic media such as hard disks, floppy disks, and magnetic tapes, optical media such as CD-ROMs, DVDs, magneto-optical media such as floptical disks, and hardware devices specially configured to store and execute computer program instructions such as ROMs, RAMs, flash memory, and the like. Computer program instructions may include machine language code generated by a compiler and high-level language code that can be executed by a computer using an interpreter, etc.

The terms "include," "comprise," or "have" as used herein, unless otherwise specifically stated, imply that the component in question may be included, and therefore should be construed to include other components rather than to exclude other components. All terms, including technical or scientific terms, unless otherwise defined, have the same meaning as commonly understood by one of ordinary skill in the art to which the embodiments disclosed herein belong. Commonly used terms, such as those defined in the dictionary, should be interpreted to be consistent with their meaning in the context of the relevant technology and not in an idealized or overly formal sense, unless explicitly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to explain rather than limit the technical ideas of the embodiments disclosed in this document, and the scope of the technical ideas disclosed in this document is not limited by these embodiments. The scope of protection of the technical idea disclosed in this document should be interpreted by the claims below, and all technical ideas within the equivalent scope thereof should be interpreted as being included in the scope of rights of this document.

## Claims

1. A battery management device comprising:
an interface configured to acquire battery data of a battery having a composite negative electrode based on a first active material of a silicon series and a second active material of a graphite series; and
a controller configured to:
calculate a first negative electrode loading of the first active material for the composite negative electrode and a second negative electrode loading of the second active material for the composite negative electrode based on the battery data; and
diagnose a state of the composite negative electrode based on the first negative electrode loading and the second negative electrode loading.

2. The battery management device of claim 1, wherein the controller is configured to diagnose the state of the composite negative electrode based on a variation in the first negative electrode loading and the second negative electrode loading according to an increase in the number of charging/discharging times of the battery.

3. The battery management device of claim 2, wherein the controller is configured to diagnose the composite negative electrode such that a degradation of the first active material is smaller than a degradation of the second active material when a first trend in which the first negative electrode loading increases while the second negative electrode loading decreases is maintained as the number of charging/discharging times of the battery increases.

4. The battery management device of claim 3, wherein the controller is configured to diagnose the composite negative electrode such that the degradation of the first active material is greater than the degradation of the second active material when the first trend transitions to a second trend in which the second negative electrode loading increases while the first negative electrode loading decreases.

5. The battery management device of claim 4, wherein the controller is configured to diagnose the composite negative electrode as having progressed through a crystalline degradation stage and an amorphous degradation stage of the first active material when the first trend transitions to the second trend.

6. The battery management device of claim 5, wherein the controller is configured to estimate a progress rate of the crystalline degradation stage and a progress rate of the amorphous degradation stage based on the first negative electrode loading and the second negative electrode loading when the first trend transitions to the second trend.

7. The battery management device of claim 4, wherein the controller is configured to diagnose that lithium precipitation occurs in the composite negative electrode when the first trend is maintained, and diagnose that side reaction gas occurs in the composite negative electrode when the first trend transitions to the second trend.

8. A battery management method comprising the steps of:
acquiring battery data of a battery having a composite negative electrode based on a first active material of a silicon series and a second active material of a graphite series;
calculating a first negative electrode loading of the first active material for the composite negative electrode and a second negative electrode loading of the second active material for the composite negative electrode based on the battery data; and
diagnosing a state of the composite negative electrode based on the first negative electrode loading and the second negative electrode loading.

9. The battery management method of claim 8, wherein the step of diagnosing the state of the composite negative electrode includes a step of diagnosing the state of the composite negative electrode based on a variation in the first negative electrode loading and the second negative electrode loading according to an increase in the number of charging/discharging times of the battery.

10. The battery management method of claim 9, wherein the step of diagnosing the state of the composite negative electrode includes a step of diagnosing the composite negative electrode such that a degradation of the first active material is smaller than a degradation of the second active material when a first trend in which the first negative electrode loading increases while the second negative electrode loading decreases is maintained as the number of charging/discharging times of the battery increases.

11. The battery management method of claim 10, wherein the step of diagnosing the state of the composite negative electrode includes a step of diagnosing the composite negative electrode such that the degradation of the first active material is greater than the degradation of the second active material when the first trend transitions to a second trend in which the second negative electrode loading increases while the first negative electrode loading decreases.

12. The battery management method of claim 11, wherein the step of diagnosing the state of the composite negative electrode includes a step of diagnosing the composite negative electrode as having progressed through a crystalline degradation stage and an amorphous degradation stage of the first active material when the first trend transitions to the second trend.

13. The battery management method of claim 12, wherein the step of diagnosing the state of the composite negative electrode includes a step of estimating a progress rate of the crystalline degradation stage and a progress rate of the amorphous degradation stage based on the first negative electrode loading and the second negative electrode loading when the first trend transitions to the second trend.

14. The battery management method of claim 11, the step of diagnosing the state of the composite negative electrode includes:
a step of diagnosing that lithium precipitation occurs in the composite negative electrode when the first trend is maintained; and
a step of diagnosing that side reaction gas occurs in the composite negative electrode when the first trend transitions to the second trend.

15. A battery system comprising:
a battery having a composite negative electrode based on a first active material of a silicon series and a second active material of a graphite series;
a power device configured to perform at least one of charging and discharging of the battery; and
a battery management device configured to acquire battery data of a battery, calculate a first negative electrode loading of the first active material for the composite negative electrode and a second negative electrode loading of the second active material for the composite negative electrode based on the battery data, and diagnose a state of the composite negative electrode based on the first negative electrode loading and the second negative electrode loading.
